# EUROPEAN PATENT SPECIFICATION

(11) **EP 4 372 805 B1**
(45) Date of publication and mention of the grant of the patent: **11.11.2026**
(21) Application number: 22216766.0
(22) Date of filing: 27.12.2022
(51) Int. Cl.: H10W 40/70, H10W 40/73, C09K 5/06

(54) **METHOD FOR MANUFACTURING ELECTRONIC ASSEMBLY**
VERFAHREN ZUR HERSTELLUNG EINER ELEKTRONISCHEN BAUGRUPPE
PROCÉDÉ DE FABRICATION D'UN ENSEMBLE ÉLECTRONIQUE

(30) Priority: 16.11.2022 TW 111143680
(43) Date of publication of application: 22.05.2024
(73) Proprietor: Micro-Star Int'l Co., Ltd., New Taipei City (TW); MSI Computer (Shenzhen) Co., Ltd., Shenzhen City Guangdong Province, P.R.C. Guangdong (CN)
(72) Inventor: CHEN, Cheng-Lung, New Taipei City (TW); CHANG, Chia-Ming, Taipei City (TW)
(74) Representative: dompatent

(56) References cited:
- WO-A1-2019/094001
- CN-A- 114 874 758
- US-A1- 2003 085 475
- US-A1- 2008 001 282
- US-A1- 2014 061 893
- US-A1- 2020 083 143

## Description

### Technical Field

The disclosure relates to a method for manufacturing an electronic assembly, more particularly to a method for manufacturing such electronic assembly including an anti-overflow part.

### Background

A phase change material (PCM) absorbs a large amount of heat when melting. Thus, some manufacturers place the phase change material between a processor and a copper block in a gaming laptop. Accordingly, the heat generated by the processor can be effectively transferred to the copper block via the liquid phase change material, thereby maintaining the processor in a desired temperature range.

However, after the phase change material melts, the liquid phase change material can hardly be kept between the copper block and the processor. That is, the liquid phase change material is easily pumped out or overflows out of the space between the copper block and the processor. In this way, the efficiency for the phase change material to transfer heat between the processor and the copper block is reduced, and the electronic components around the processor may be damaged due to the liquid phase change material flowing thereto.
WO 2019/094001 A1 discloses a thermal interface structure having an edge structure and a thermal interface material.
US 2003/0085475 A1 discloses a semiconductor package having a dam.
US 2014/0061893 A1 discloses a hybrid thermal interface material for IC packages with an integrated heat spreader.
US 2008/0001282 A1 discloses a microelectronic assembly having a periphery seal around a thermal interface material.
CN 114874758 A discloses an indium-based efficient heat-conducting gasket.
US 2020/0083143 A1 discloses an electronic device including a main substrate, a semiconductor package structure and a heat pipe.

### SUMMARY

The disclosure provides a method for manufacturing an electronic assembly, to prevent a liquid thermally conductive sheet or a liquid phase change part from overflowing out of a space between a heat source and a thermally conductive block by an anti-overflow element or an anti-overflow part.

One embodiment of this disclosure provides a method for manufacturing an electronic assembly including a step of placing an anti-overflow element on a side of a heat source located farthest away from a circuit board, a step of placing a thermally conductive material layer that has a larger width relative to an opening of the anit-overflow element and made of a phase change material on a side of the anti-overflow element located farthest away from the heat source, and a step of fitting the thermally conductive material layer in the anti-overflow element by compressing the thermally conductive material layer to form a thermally conductive sheet surrounded by the anti-overflow element, and a step of placing a thermally conductive block on a side of the anti-overflow element located farthest away from the heat source. Opposite sides of the thermally conductive sheet are in thermal contact with the heat source and the thermally conductive block, respectively.

According the method for manufacturing the electronic assembly, according to the above embodiments, since the thermally conductive sheet is surrounded by the anti-overflow element, the anti-overflow element prevents the liquid thermally conductive sheet from overflowing out of the space between the heat source and the thermally conductive block after the thermally conductive sheet melts. Accordingly, the efficiency for the thermally conductive sheet to transfer the heat generated by the heat source to the thermally conductive block 400 is maintained, and the liquid thermally conductive sheet is prevented from flowing to the electronic components adjacent to the heat source. In addition, since the opening of the anti-overflow part exposes a part of the phase change part, when the composite thermally conductive sheet is disposed between the heat source and the thermally conductive block, the anti-overflow part of the composite thermally conductive sheet can achieve the same effect as the anti-overflow element.

### BRIEF DESCRIPTION OF THE DRAWINGS

The present disclosure will become better understood from the detailed description given herein below and the accompanying drawings which are given by way of illustration only and thus are not intending to limit the present disclosure and wherein:
FIG. 1 is a side cross-sectional view of an electronic assembly;
FIG. 2 is a schematic top view showing a heat source, an anti-overflow element and a thermally conductive sheet of the electronic assembly in FIG. 1;
FIGS. 3-5 are side cross-sectional views showing a method for manufacturing the electronic assembly in FIG. 1;
FIG. 6 is a side cross-sectional view of an electronic assembly; and
FIG. 7 is a perspective view of a composite thermally conductive sheet;

### DETAILED DESCRIPTION

In the following detailed description, for purposes of explanation, numerous specific details are set forth in order to provide a thorough understanding of the disclosed embodiments. It will be apparent, however, that one or more embodiments may be practiced without these specific details. In other instances, well-known structures and devices are schematically shown in order to simplify the drawing.

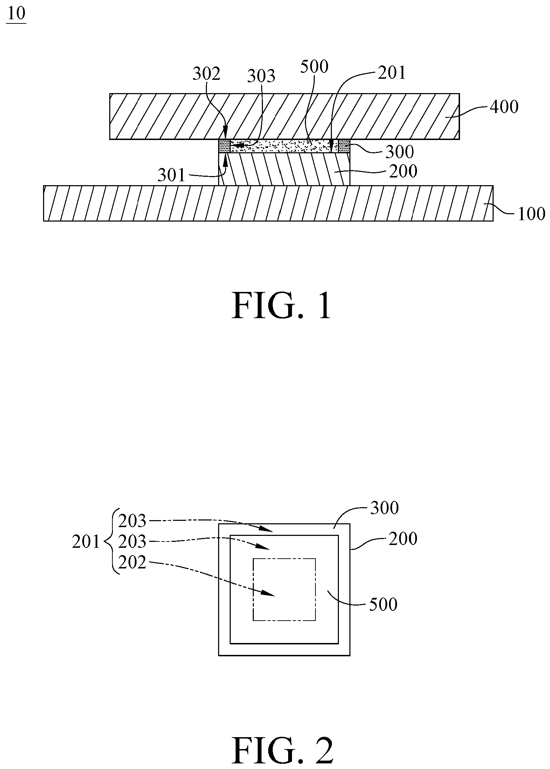

Please refer to FIGS. 1-2. FIG. 1 is a side cross-sectional view of an electronic assembly 10. FIG. 2 is a schematic top view showing a heat source 200, an anti-overflow element 300 and a thermally conductive sheet 500 of the electronic assembly 10 in FIG. 1.

The electronic assembly 10 is disposed in, for example, a laptop computer (not shown). In this embodiment, the electronic assembly 10 includes a circuit board 100, the heat source 200, the anti-overflow element 300 (may also be referred as an overflow protector), a thermally conductive block 400 and the thermally conductive sheet 500 made of a phase change material (PCM).

The heat source 200 is, for example, a processor such as a central processing unit (CPU). The heat source 200 is disposed on and electrically connected to the circuit board 100. In this embodiment, the anti-overflow element 300 is made of, for example, Indium (In). In this embodiment, the anti-overflow element 300 has a bottom surface 301, a top surface 302 and an opening 303. The bottom surface 301 and the top surface 302 face away from each other. The opening 303 extends from the bottom surface 301 to the top surface 302. The bottom surface 301 of the anti-overflow element 300 is disposed on a side of the heat source 200 that is located farthest away from the circuit board 100; that is, the bottom surface 301 of the anti-overflow element 300 faces a thermal contact surface 201 of the heat source 200 facing away from the circuit board 100.

The thermally conductive block 400 is disposed on a side of the anti-overflow element 300 that is located farthest away from the heat source 200. In this embodiment, the thermally conductive block 400 is, for example, a copper block. That is, the thermally conductive block 400 is made of, for example, copper. Thus, in this embodiment, the anti-overflow element 300 and the thermally conductive block 400 are made of, for example, different materials.

The thermally conductive sheet 500 is located in the opening 303 of the anti-overflow element 300 to be surrounded by the anti-overflow element 300. Opposite sides of the thermally conductive sheet 500 are in thermal contact with the heat source 200 and the thermally conductive block 400, respectively. In this embodiment, the thermally conductive sheet 500 is made of, for example, an alloy of Indium, Bismuth (Bi) and Tin (Sn).

After the thermally conductive sheet 500 melts, the anti-overflow element 300 prevents the liquid thermally conductive sheet 500 from overflowing out of a space between the heat source 200 and the thermally conductive block 400. Accordingly, the efficiency for the thermally conductive sheet 500 to transfer the heat generated by the heat source 200 to the thermally conductive block 400 is maintained, and the liquid thermally conductive sheet 500 is prevented from flowing to the electronic components (not shown) adjacent to the heat source 200.

Moreover, in this embodiment, a melting point of the anti-overflow element 300 is, for example, higher than a melting point of the thermally conductive sheet 500. Thus, after the thermally conductive sheet 500 absorbs the heat generated by the heat source 200 and melts, the anti-overflow element 300 is still in the solid state and thus is able to prevent the liquid thermally conductive sheet 500 from overflowing out of the space between the heat source 200 and the thermally conductive block 400. Further, in this embodiment, the anti-overflow element 300 is made of, for example, Indium. The thermally conductive sheet 500 is made of, for example, an alloy of Indium, Bismuth and Tin. That is, the metal material of the anti-overflow element 300 is one of the metal materials included in the alloy of the thermally conductive sheet 500. Thus, some of the liquid thermally conductive sheet 500 is bonded to the anti-overflow element 300 and thus is prevented from overflowing out of the space between the heat source 200 and the thermally conductive block 400.

In addition, in this embodiment, as shown in FIG. 2, the thermal contact surface 201 includes a hot area 202 and a cold area 203 that are connected to each other. During the operation of the heat source 200, most of the heat generated by the heat source 200 is transferred to the hot area 202 so that a temperature on the hot area 202 is higher than a temperature on the cold area 203. In addition, the anti-overflow element 300 is disposed on, for example, the cold area 203. Also, the thermally conductive sheet 500 is in thermal contact with, for example, the hot area 202. Since most of the heat generated by the heat source 200 is transferred to the hot area 202, the thermally conductive sheet 500 in thermal contact with the hot area 202 is able to effectively absorb most of the heat generated by the heat source 200.

Note that in other embodiments, a plurality of ribs may be disposed in the opening of the anti-overflow element. The ribs and the anti-overflow element may together be in a mesh shape. That is, these ribs divide the opening of the anti-overflow element into a plurality of accommodation spaces for the liquid thermally conductive sheet to be accommodated therein.

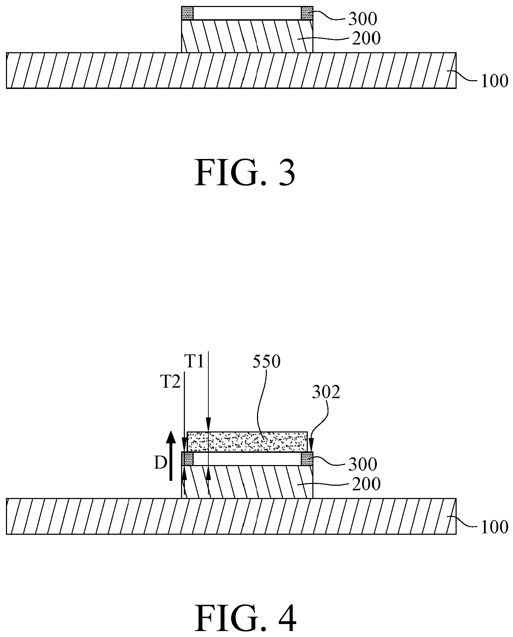

Please refer to FIGS. 3-5. FIGS. 3-5 are side cross-sectional views showing a method for manufacturing the electronic assembly 10 in FIG. 1. The method for manufacturing the electronic assembly 10 in FIG. 1 includes following steps.

As shown in FIG. 3, the anti-overflow element 300 is placed on the side of the heat source 200 located farthest away from the circuit board 100. Then, as shown in FIG. 4, a thermally conductive material layer 550 made of a phase change material is placed on the side of the anti-overflow element 300 located farthest away from the heat source 200; that is, the thermally conductive material layer 550 is placed on the top surface 302 of the anti-overflow element 300. Note that in this embodiment, a thickness T1 of the thermally conductive material layer 550 in a stacking direction D of the anti-overflow element 300 and the heat source 200 is, for example, larger than a thickness T2 of the anti-overflow element 300 in the stacking direction D. Specifically, the thickness T1 of the thermally conductive material layer 550 is, for example, 110% to 150% of the thickness T2 of the anti-overflow element 300.

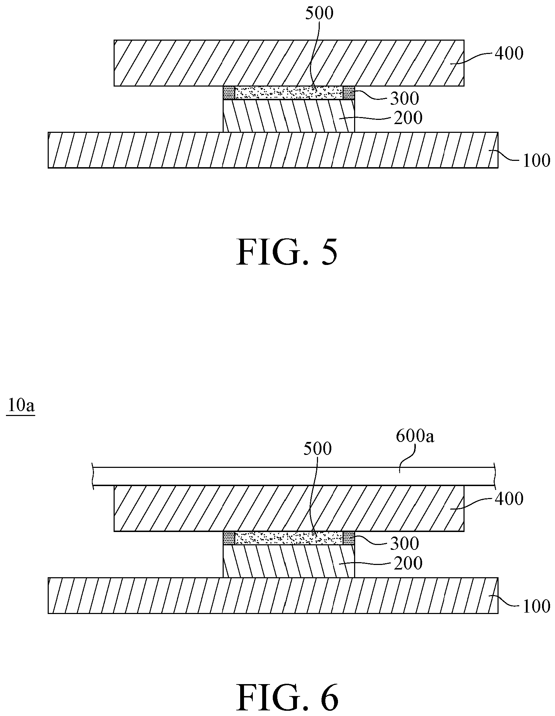

Then, as shown in FIGS. 4 and 5, the thermally conductive material layer 550 is fitted into the anti-overflow element 300 so as to form the thermally conductive sheet 500 surrounded by the anti-overflow element 300, and the thermally conductive block 400 is placed on the side of the anti-overflow element 300 located farthest away from the heat source 200. Due to the aforementioned relationship between the thickness of the thermally conductive material layer 550 and the thickness of the anti-overflow element 300 (thickness T1 being larger than thickness T2), the space between the heat source 200 and the thermally conductive block 400 is filled with the thermally conductive sheet 500 formed by the thermally conductive material layer 550 more effectively, and the heat generated by the heat source 200 is transferred to the thermally conductive block 400 via the thermally conductive sheet 500 more efficiently.

The disclosure is not limited by the structure of the electronic assembly. Please refer to FIG. 6. FIG. 6 is a side cross-sectional view of an electronic assembly 10a according to a second embodiment of the disclosure. In this embodiment, the electronic assembly 10a includes a circuit board 100, a heat source 200, an anti-overflow element 300, a thermally conductive block 400, a thermally conductive sheet 500 and at least one heat pipe 600a. The circuit board 100, the heat source 200, the anti-overflow element 300, the thermally conductive block 400 and the thermally conductive sheet 500 are the same as those in the first embodiment, and thus the relevant descriptions are omitted. The at least one heat pipe 600a is in thermal contact with a side of the thermally conductive block 400 located farthest away from the anti-overflow element 300.

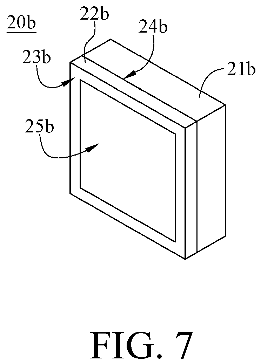

The disclosure further provides a composite thermally conductive sheet 20b. Please refer to FIG. 7. FIG. 7 is a perspective view of the composite thermally conductive sheet 20b according to a third embodiment of the disclosure. In this embodiment, the composite thermally conductive sheet 20b includes a phase change part 21b and an anti-overflow part 22b (may also be referred as an overflow protecting part). The phase change part 21b is made of an alloy of Indium, Bismuth and Tin. The anti-overflow part 22b is made of Indium. The anti-overflow part 22b has a bottom surface 23b, a top surface 24b and an opening 25b. The bottom surface 23b and the top surface 24b face away from each other. The opening 25b extends from the bottom surface 23b to the top surface 24b. The top surface 24b of the anti-overflow part 22b is stacked on a side of the phase change part 21b. The opening 25b exposes a part of the phase change part 21b. Note that the composite thermally conductive sheet 20b may be disposed on the heat source 200 in FIG. 1 to replace the anti-overflow element 300 and the thermally conductive sheet 500 in FIG. 1.

According to the electronic assembly, the method for manufacturing the electronic assembly, and the composite thermally conductive sheet according to the above embodiments, since the thermally conductive sheet is surrounded by the anti-overflow element, the anti-overflow element prevents the liquid thermally conductive sheet from overflowing out of the space between the heat source and the thermally conductive block after the thermally conductive sheet melts. Accordingly, the efficiency for the thermally conductive sheet to transfer the heat generated by the heat source to the thermally conductive block 400 is maintained, and the liquid thermally conductive sheet is prevented from flowing to the electronic components adjacent to the heat source. In addition, since the opening of the anti-overflow part exposes a part of the phase change part, when the composite thermally conductive sheet is disposed between the heat source and the thermally conductive block, the anti-overflow part of the composite thermally conductive sheet can achieve the same effect as the anti-overflow element.

Further, according to the experimental results, with respect to conventional electronic assembly without the anti-overflow element, a power of the processor (heat source) is decreased from 110 watt (W) to 80-85 W after performing a burn-in test for a certain period; with respect to the electronic assembly including the anti-overflow element according to the disclosure, a power of the processor (heat source) is maintain at 105-110 W after performing a burn-in test for the same certain period. Thus, the anti-overflow element according to the disclosure significantly enhance a reliability of the electronic assembly.

## Claims

1. A method for manufacturing an electronic assembly (10), comprising:
placing an anti-overflow element (300) on a side of a heat source (200) located farthest away from a circuit board (100);
placing a thermally conductive material layer (550) that has larger width relative to an opening of the anti-overflow element and made of a phase change material on a side of the anti-overflow element located farthest away from the heat source; and
fitting the thermally conductive material layer in the anti-overflow element by compressing the thermally conductive material layer to form a thermally conductive sheet (500) surrounded by the anti-overflow element, and placing a thermally conductive block (400) on a side of the anti-overflow element located farthest away from the heat source, wherein opposite sides of the thermally conductive sheet are in thermal contact with the heat source and the thermally conductive block, respectively.

2. The method for manufacturing an electronic assembly according to claim 1, wherein a thickness of the thermally conductive material layer is larger than a thickness of the anti-overflow element.

3. The method for manufacturing an electronic assembly according to claim 2, wherein the thickness of the thermally conductive material layer is 110% to 150% of the thickness of the anti-overflow element.

## Patentansprüche

1. Verfahren zur Herstellung einer elektronischen Baugruppe (10), das umfasst:
Platzieren eines Überlaufschutzelements (300) auf einer Seite einer Wärmequelle (200), die am weitesten von einer Leiterplatte (100) entfernt ist;
Platzieren einer wärmeleitenden Materialschicht (550), die im Verhältnis zu einer Öffnung des Überlaufschutzelements eine größere Breite aufweist und aus einem Phasenwechselmaterial besteht, auf einer Seite des Überlaufschutzelements, die am weitesten von der Wärmequelle entfernt ist; und
Einpassen der wärmeleitenden Materialschicht in das Überlaufschutzelement durch Komprimieren der wärmeleitenden Materialschicht, um eine vom Überlaufschutzelement umschlossene wärmeleitende Folie (500) zu bilden, und Platzieren eines wärmeleitenden Blocks (400) auf einer Seite des Überlaufschutzelements, die am weitesten von der Wärmequelle entfernt ist, wobei gegenüberliegende Seiten der wärmeleitenden Folie jeweils in thermischem Kontakt mit der Wärmequelle und dem wärmeleitenden Block stehen.

2. Verfahren zur Herstellung einer elektronischen Baugruppe nach Anspruch 1, wobei die Dicke der wärmeleitenden Materialschicht größer ist als eine Dicke des Überlaufschutzelements.

3. Verfahren zur Herstellung einer elektronischen Baugruppe nach Anspruch 2, wobei die Dicke der wärmeleitenden Materialschicht 110 % bis 150 % der Dicke des Überlaufschutzelements beträgt.

## Revendications

1. Procédé de fabrication d'un ensemble électronique (10), comprenant :
la mise en place d'un élément anti-débordement (300) sur un côté d'une source de chaleur (200) située la plus éloignée d'une carte de circuit imprimé (100) ;
la mise en place d'une couche de matériau thermoconducteur (550) qui a une largeur supérieure par rapport à une ouverture de l'élément anti-débordement et est constituée d'un matériau à changement de phase sur un côté de l'élément anti-débordement situé le plus éloigné de la source de chaleur ; et
l'ajustement de la couche de matériau thermoconducteur dans l'élément anti-débordement par compression de la couche de matériau thermoconducteur pour former une feuille thermoconductrice (500) entourée par l'élément anti-débordement, et la mise en place d'un bloc thermoconducteur (400) sur un côté de l'élément anti-débordement situé le plus éloigné de la source de chaleur, dans lequel des côtés opposés de la feuille thermoconductrice sont en contact thermique respectivement avec la source de chaleur et le bloc thermoconducteur.

2. Procédé de fabrication d'un ensemble électronique selon la revendication 1, dans lequel une épaisseur de la couche de matériau thermoconducteur est supérieure à une épaisseur de l'élément anti-débordement.

3. Procédé de fabrication d'un ensemble électronique selon la revendication 2, dans lequel l'épaisseur de la couche de matériau thermoconducteur représente 110 % à 150 % de l'épaisseur de l'élément anti-débordement.
